(19) **Europäisches Patentamt**
**European Patent Office**
**Office européen des brevets**

(11) **EP 2 198 142 B1**

(12) **EUROPEAN PATENT SPECIFICATION**

(45) Date of publication and mention
of the grant of the patent:
**14.06.2017 Bulletin 2017/24**

(21) Application number: **08806914.1**

(22) Date of filing: **20.08.2008**

(51) Int Cl.:
*G01R 19/25* (2006.01)    *F02D 41/02* (2006.01)
*F16K 51/00* (2006.01)

(86) International application number:
**PCT/IB2008/002200**

(87) International publication number:
**WO 2009/030994 (12.03.2009 Gazette 2009/11)**

(54) **CONTROL SYSTEM**

STEUERUNGSSYSTEM

SYSTÈMES DE COMMANDE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **05.09.2007 GB 0717208**

(43) Date of publication of application:
**23.06.2010 Bulletin 2010/25**

(73) Proprietor: **Valtra Inc
44201 Suolahti (FI)**

(72) Inventor: **VESALA, Aleski, Viljami
FIN-31110 Matku (FI)**

(74) Representative: **Morrall, Roger
AGCO Limited
Abbey Park
Stoneleigh
Kenilworth CV8 2TQ (GB)**

(56) References cited:
**JP-A- 11 171 496**

- **CRAIG K: "The role of computers in
mechatronics" COMPUTING IN SCIENCE AND
ENGINEERING, IEEE SERVICE CENTER, LOS
ALAMITOS, CA, US, vol. 5, no. 2, 1 March 2003
(2003-03-01), pages 80-85, XP011095990 ISSN:
1521-9615**
- **KAISER U: "WAVE DIGITAL FILTERING FOR TI'S
SENSOR SIGNAL PROCESSOR MSP430" TEXAS
INSTRUMENTS TECHNICAL JOURNAL, TEXAS
INSTRUMENTS, DALLAS, TX, US, 1 November
1994 (1994-11-01), pages 65-83, XP000749181
ISSN: 0893-7877**

**Description**

This invention relates to control systems and in particular to current feedback control systems. Such control systems are used, for example, to control the operation of solenoid-operated devices such as solenoid-operated fluid control valves in a fluid control circuit. Such circuits are used, for example, to control the operation of a wide variety of functions on agricultural tractors or similar vehicles.

Conventionally such solenoid-operated devices are controlled using pulse width modulation (PWM) in which the voltage applied to the solenoid-operated device is a square wave whose pulse ratio (the ratio of its on and off period) depends on the required average voltage which is desired to apply to the solenoid-operated device.

Conventionally also, such control circuits sense the current applied to the device in order to provide a more accurate control to, for example, compensate for the changes in current due to the heating or cooling of the valve solenoid. This current sensing causes problems with a PWM system since the electrical current in such systems is of saw tooth form and typically operates with a 100Hz PWM frequency or more. The saw tooth wave consists of the fundamental frequency (e.g. 100Hz) and its harmonics (200, 300,... Hz). These harmonics in turn cause problems when trying to measure the current with a relative low cost processor as the processor is not capable of operating at the sampling frequency required to accurately measure these harmonics. Document JP11171496 discloses sampling a filtering 2 kHz ripple from a 100 Hz dither signal leaving a signal consisting of a clean 100 Hz sine wave. It is an object of the present invention to provide a method of measuring current in the above type of control system which can be carried out using a relatively inexpensive processor and also provides circuitry for making such current measurements.

Thus according to the present invention there is provided a method of measuring current using a microprocessor in a control system in which the current is created by a square-wave PWM signal operating at a PWM frequency, the method comprising:-

a) sampling a PWM based current signal, which is in the form of a saw-tooth like wave, at a frequency such that harmonics of the current signal will fold to a set number of frequencies which the microprocessor can measure accurately, and
b) filtering the resultant signal to eliminate the set number of folded frequencies to obtain a clean, average and fast reacting signal which is representative of the measured current.

Thus, for example, with a PWM signal of 100Hz frequency the PWM signal is sampled at 250Hz. This means that, in accordance with the Shannon sampling theorem, all frequencies below 125Hz will be measured correctly and all frequencies above 125Hz will alias or fold. The resulting signal is then filtered to remove these aliased or folded frequencies so that a representative current signal is obtained.

The filtering is preferably done by a notch filter which is preferably of the FIR (finite impulse response) type. The FIR filter may use a moving average algorithm.

With a 100Hz PWM frequency the harmonics of 200Hz and 300Hz fold to 50Hz, the 400Hz harmonic folds to 100Hz. The notch filter is therefore set to filter out the 50Hz and 100Hz frequencies.

The present invention also provides an electrical control circuit in which the current in the circuit is measured by the above method.

The present invention will now be described, by way of example only, with reference to the accompanying drawing in which:

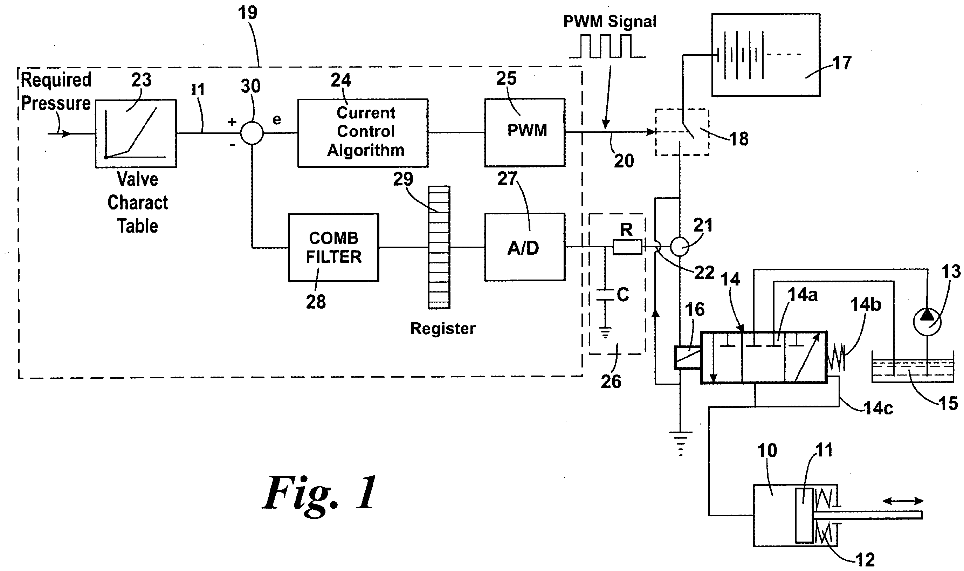

Figure 1 is a diagrammatic representation of a hydraulic control system for use in an agricultural tractor which includes a PWM system using the current measurement techniques of the present invention.

Referring to the drawing, the level of fluid pressure applied to a working chamber 10 in which a piston 11 moves is to be controlled. This pressure could be used, for example, to engage a clutch in a gearbox of a tractor to select a particular gearbox ratio. The fluid pressure is provided by a pump 13 via fluid control valve 14. The fluid which is exhausted from chamber 10 is returned to a tank 15 via valve 14. The pressure in chamber 10 moves the piston 11 to the right as viewed in Figure 1 to engage the clutch and a spring 12 moves the piston to the left to disengage the clutch.

The level of pressure in chamber 10 is controlled by the movement of the spool 14a of valve 14 which is controlled by a solenoid 16 which is powered from a battery 17 via a field effect transistor (FET) 18 which is in turn controlled by a PWM signal supplied from an associated micro-processor 19 via a line 20.

Micro-processor 19 applies to a summing junction 30 a current signal I1 which corresponds to the desired level of pressure in chamber 10 and which is derived from a valve pressure/current characteristic represented diagrammatically in Figure 1 at 23. The error 'e' between this setpoint and the actual current signal applied to solenoid 16 which is fed back to summing junction 30 via line 22 is modified by a current control algorithm (such as a PID algorithm) represented diagrammatically at 24 in Figure 1. The error signal 'e' enters a PWM module 25 which provides a PWM signal of the appropriate % (i.e. on/off ratio) which is then applied to FET 18 via line 20.

The voltage applied to solenoid 16 by battery 17 is thus applied in a square tooth form and the resulting current is measured by a current sensor 21 and fed back into micro-processor 19 via line 22 as the feedback control signal for comparison with the initial control signal I1 to ensure that the desired pressure in chamber 10 is maintained. The force applied to valve spool 14a acts against a return spring 14b and the pressure in chamber 10 which is fed back on to the spool 14a by line 14c

The present invention is concerned with the manner in which an accurate feedback signal is applied to the summing junction 30 via line 22 and it will be understood that the present invention is applicable to a wide range of control systems which employ PWM with a current feedback control loop and not simply to hydraulic pressure control systems.

In the example described the micro-processor used is a Motorola MC68376 which forms part of an electronic control unit SC12 A09 Vansco-Forssa.

In accordance with the present invention, the PWM module 25 supplies the signal at line 20 at a frequency of 100Hz. The current is sampled using sensor 21 at a frequency of 250 Hz which is a frequency which the SC12 control unit can comfortably handle leaving sufficient processing time for the processor to handle its main task of controlling the associated transmission.

The data from sensor 21 passes through a low pass type anti-aliasing filter 26 (typically an RC type) that attenuates the yet higher frequencies and then through an analogue to digital converter 27. In the sampling process all those frequencies above 125Hz will alias or fold. Especially the harmonics of the PWM frequency fold to a set number of frequencies. These folded or aliased harmonic frequencies are then filtered out by a comb filter 28 of the FIR (finite impulse response) type which operates in conjunction with a memory register 29 which stores the measured current values at, for example, successive time intervals such as interval K (current time), K-1 previous time interval, K-2 yet older time interval etc.

Thus if $X_K$ is the measured current value at the current time interval and values $X_{K-1}$ and $X_{K-2}$ are the measured values at the two previous time intervals then the current output of the filter $Y_K$ can be written as

$$Y_K = a_o . X_K + a_1 . X_{K-1} + a_2 . X_{K-2} + a_3 . X_{K-3} + \ldots\ldots$$

where $a_o$ is the filter coefficient for time interval $X_K$, a1 is the coefficient for time interval $X_{K-1}$ etc.

As will be appreciated the number and value of the coefficients defines the filter characteristics.

For example, the filter can be set up to provide a moving average with all coefficients equal in value using an algorithm

$$Y_K = 1/3 . X_K + 1/3 . X_{K-1} + 1/3 \ X_{K-2}$$

$$= \frac{X_K + X_{K-1} + X_{K-2}}{3}$$

The main harmonics of the 100Hz PWM signal after the lowpass filter are at 200Hz, 300HZ and 400Hz. The 200Hz and 300Hz harmonics fold to a 50Hz signal and the 400Hz harmonic folds to a 100Hz signal. The notch filter is therefore set to filter out the 50Hz and 100Hz frequencies to leave a signal which is representative of average current and which is therefore suitable for use as a feedback signal in the valve control system.

**Claims**

1.    A method of measuring current using a microprocessor (19) in a control system in which the current is created by a square-wave PWM voltage signal operating at a PWM frequency, the method comprising:-

a) sampling a PWM based current signal, which is in the form of a saw-tooth like wave, at a frequency such that harmonics of the current signal will fold to a set number of frequencies within a range of frequencies which the microprocessor can measure accurately, and
b) filtering the resultant signal to eliminate the set number of folded frequencies to obtain a clean, average and fast reacting signal which is representative of the measured current.

**2.** A method according to Claim 1 in which the filtering is done in a filter (28) of the FIR type.

**3.** A method according to Claim 2 in which the FIR filter uses a moving average algorithm.

**4.** A method according to any one of Claims 1 to 3 in which the PWM voltage operates at a frequency of 100Hz and the current signal is sampled at a frequency of 250Hz to filter out the 50Hz and 100Hz frequencies.

**5.** A method according to any one of Claims I to 4, in which the control system is a current feedback control system which controls a solenoid operated valve (14) in a fluid flow control system.

**6.** An electrical control circuit in which the feedback current is measured by a method according to any one of Claims 1 to 5.

**Patentansprüche**

**1.** Verfahren zum Messen eines Stroms unter Benutzung eines Mikroprozessors (19) in einem Steuer-/Regelsystem, in dem der Strom durch ein rechteckwellenförmiges PWM- Spannungssignal erzeugt wird, das bei einer PWM-Frequenz vorliegt, wobei das Verfahren das Folgende aufweist:

a) Abtasten eines PWM-basierenden Stromsignals, welches in der Form einer säge- zahnartigen Welle vorliegt, bei einer Frequenz derart, dass sich Oberwellen des Stromsignals zu einer festgelegten Anzahl von Frequenzen falten, die in einem Frequenzbereich liegen, den der Mikroprozessor präzise messen kann, und
b) Filtern des resultierenden Signals zum Eliminieren der festgelegten Anzahl gefalteter Frequenzen zum Erreichen eines sauberen, mittleren und schnell reagierenden Signals, welches repräsentativ für den gemessenen Strom ist.

**2.** Verfahren nach Anspruch 1, wobei das Filtern in einem Filter (28) des FIR-Typs erfolgt.

**3.** Verfahren nach Anspruch 2, wobei der FIR-Filter einen gleitender Durchschnitt Algorithmus benutzt.

**4.** Verfahren nach einem der Ansprüche 1 bis 3, wobei die PWM-Spannung bei einer Frequenz von 100 Hz vorliegt und das Stromsignal bei einer Frequenz von 250 Hz abgetastet wird, um die Frequenzen von 50 Hz und 100 Hz herauszufiltern.

**5.** Verfahren nach einem der Ansprüche 1 bis 4, wobei das Steuer-/Regelsystem ein Strom-Rückkopplungs-Steuer-/Regelsystem ist, welches ein Magnetventil (14) in einem Fluidfluss-Steuer-/Regelsystem regelt.

**6.** Elektrischer Steuer-/Regelkreis, wobei der Rückkopplungsstrom durch ein Verfahren nach einem der Ansprüche 1 bis 5 gemessen wird.

**Revendications**

**1.** Procédé de mesure de courant utilisant un microprocesseur (19) dans un dispositif de commande dans lequel le courant est créé par un signal de tension à modulation de largeur d'impulsion (PWM) en onde carrée fonctionnant à une fréquence de modulation PWM, le procédé comprenant :

a) l'échantillonnage d'un signal de courant basé sur une modulation PWM, qui est sous forme d'une onde en dents de scie, à une fréquence telle que des harmoniques du signal de courant se replient sur un nombre défini de fréquences dans une plage de fréquences que le microprocesseur peut mesurer précisément, et
b) le filtrage du signal résultant de manière à éliminer le nombre défini de fréquences repliées afin d'obtenir un signal de réaction propre, lisse et rapide qui est représentatif du courant mesuré.

**2.** Procédé selon la revendication 1, dans lequel le filtrage est réalisé dans un filtre (28) du type FIR.

**3.** Procédé selon la revendication 2, dans lequel le filtre FIR utilise un algorithme à moyenne glissante.

4. Procédé selon l'une quelconque des revendications 1 à 3, dans lequel le signal de modulation PWM présente une fréquence de 100 Hertz et le signal de courant est échantillonné à une fréquence de 250 Hertz afin de filtrer les fréquences de 50 Hertz et 100 Hertz.

5. Procédé selon l'une quelconque des revendications 1 à 4, dans lequel le dispositif de commande est un dispositif de commande d'asservissement de courant qui commande une électrovanne (14) dans un dispositif de commande d'écoulement de fluide.

6. Circuit de commande électrique dans lequel le courant d'asservissement est mesuré par un procédé selon l'une quelconque des revendications 1 à 5.

*Fig. 1*

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11171496 B